# FASCICULE DE BREVET EUROPEEN

(11) **EP 1 018 092 B1**
(45) Date de publication et mention de la délivrance du brevet: **22.12.2010**
(21) Numéro de dépôt: 98946510.9
(22) Date de dépôt: 23.09.1998
(51) Int. Cl.: G06K 19/077

(54) **PROCEDE DE FABRICATION D'UN MODULE OU ETIQUETTE ELECTRONIQUE, MODULE OU ETIQUETTE OBTENU ET SUPPORT COMPORTANT UN TEL MODULE OU ETIQUETTE**
VERFAHREN ZUR HERSTELLUNG EINES ELEKTRONISCHEN MODULS ODER ETIKETTS, DERART HERGESTELLTES MODUL ODER ETIKETT UND TRÄGER MIT SOLCHEM MODUL ODER ETIKETT
METHOD FOR MAKING AN ELECTRONIC MODULE OR LABEL, RESULTING ELECTRONIC MODULE OR LABEL AND MEDIUM CONTAINING SUCH A MODULE OR LABEL

(30) Priorité: 26.09.1997 FR 9712445
(43) Date de publication de la demande: 12.07.2000
(73) Titulaire: Gemalto SA, 92190 Meudon (FR)
(72) Inventeur: ELBAZ, Didier, F-13010 Marseille (FR); FIDALGO, Jean-Christophe, F-13420 Gémenos (FR)
(86) Numéro de dépôt international: PCT/FR1998/002052
(87) Numéro de publication internationale: WO 1999/017253

(56) Documents cités:
- EP-A- 0 201 952
- EP-A- 0 299 530
- DE-A- 3 924 439

## Description

La présente invention concerne la fabrication des modules électroniques destinés à être intégrés dans une carte électronique, telle qu'une carte à puce ou une étiquette électronique.

Ce module électronique comprend au moins un microcircuit et une interface qui peut être un bornier de contacts, dans le cas des cartes à puce classiques à contact, ou une ou plusieurs antennes permettant une communication sans contact, dans le cas des cartes à puce sans contact et des étiquettes électroniques. Dans le cas des cartes à puce hybrides, l'interface comprend un bornier de contact et une antenne.

Un procédé usuel pour la fabrication des cartes à puce consiste à réaliser en série des modules électroniques sur un film support continu puis à les découper ensuite pour les fixer dans une cavité aménagée dans le corps de la carte. Plus précisément, des microcircuits ou puces sont collés sur le film support portant une interface, puis on réalise des connexions du microcircuit à l'interface. Les connexions et la puce sont ensuite recouverts d'un enrobage notamment par une goutte de résine thermodurcissable servant de protection mécanique.

Ensuite on procède à une opération de fixation des modules électroniques dans la cavité de la carte, communément appelée "encartage". Pour cela, on peut disposer un adhésif dans la cavité telle une colle cyanocrylate ou même un adhésif thermo-activable. Alternativement, l'adhésif thermoactivable peut être déposé sur le film par lamination à chaud après l'enrobage et avant découpe du module. On réactive ensuite l'adhésif par un pressage à chaud une fois le module reporté dans la cavité.

L'opération de dépôt de la résine de protection est en général effectuée directement sur les films supports pour des puces de petites dimensions. Par contre, pour des microcircuits de taille importante et notamment de forme rectangulaire, il est nécessaire de délimiter la surface de la goutte de résine au moyen d'une "barrière" déposée autour du module électronique pour obtenir une forme reproductible. L'utilisation de la barrière facilite le dépôt de la résine et peut permettre, dans certains cas, de s'affranchir de l'opération de rectification par fraisage qui est nécessaire pour mettre le module à épaisseur.

Cette barrière peut être en polymère (époxy, silicone, polyester) et déposée par un procédé de dépôt au moyen d'une seringue ("dispense") ou par sérigraphie. La barrière peut également être constituée d'un cadre de métal estampé collé sur le film support.

Cette technique utilisant la barrière présente un certain nombre d'inconvénients. Tout d'abord, son coût est relativement important et grève le prix de revient de la carte électronique. Dans le cas d'une barrière en silicone, il y a des effets secondaires (pollution des surfaces à coller). Il est nécessaire de bien maîtriser l'opération de dépôt de la résine pour éviter des débordements de résine, ce qui constitue une source de rebut. Enfin, il est difficile de s'affranchir de l'opération de fraisage dans le cas de résines thermodurcissables.

Pour s'affranchir des inconvénients ci-dessus un autre procédé comporte des étapes consistant à laminer à froid un ruban adhésif perforé sur le film support, couler une résine dans les évidements laissés par les perforations du ruban adhésif, selon un procédé dit de "coffrage", mettre à l'épaisseur, si nécessaire, par tamponnage et décoller le ruban adhésif.

Ce procédé utilise un consommable spécifique, le ruban adhésif, de coût non négligeable. Par ailleurs, pour que cette technologie soit de faible coût, il faut découper et déposer le ruban adhésif sur la même machine que celle déposant la résine et ôtant le ruban. De plus, on ne peut pas tolérer le moindre résidu d'adhésif sur le film pour ne pas nuire à l'opération d'encartage. Ces deux objectifs sont difficiles à réaliser avec un bon rendement, le moindre décalage dans le report du ruban adhésif générant un rebut important. Il est difficile d'appliquer un adhésif à froid qui devra être décollé après enrobage sans qu'il y ait des amorces de décollement de l'adhésif au voisinage de la découpe qui créent des fuites de résine à l'extérieur de la surface prévue.

Une autre technique est décrite dans la demande de brevet européen EP-A-0.201.952. Elle comporte des étapes consistant à laminer à froid un ruban adhésif perforé sur un film nu et/ou comportant la puce et/ou les fils de connexion, ledit ruban étant constitué d'une masse adhésive et d'une feuille de protection amovible, à pulvériser un vernis sur la feuille protectrice enrobant ainsi la puce et les connexions, à enlever la feuille protectrice qui a servi de masque, à découper le module à l'aide d'un outil du type poinçon / matrice et à le reporter directement dans la cavité.

Ce procédé est difficile à mettre en oeuvre et sa fiabilité mécanique est discutable. En effet, lors de la découpe la masse adhésive restante risque d'adhérer à la matrice et/ou la carte. On a alors recours à une deuxième feuille protectrice présentant des évidements correspondant aux modules que l'on vient placer sur la masse adhésive.

Ce procédé a l'inconvénient de comporter trop d'étapes, de nécessiter le deuxième film en tant que consommable spécifique et donc d'être onéreux à mettre en oeuvre.

Le document EP-A-0-299 530 décrit les étapes d'obtention d'un module correspondant au préambule de la revendication 1. Le module de carte à puce comporte un film adhésif servant à la liaison avec un corps de carte. Le film comporte un évidement autour de l'emplacement de la puce de manière à délimiter un matériau d'enrobage de la puce et de ses connexions filaires. Le film adhésif peut avoir une adhésivité activable. Une couche de protection de l'adhésif peut être prévue.

Le problème à la base de l'invention est de fournir un procédé de fabrication de modules électroniques pour cartes électroniques qui soit simple, fiable et économique.

La solution proposée vise non seulement à réduire le nombre d'étapes mais aussi à supprimer les consommables. Pour cela, le principe de l'invention est d'utiliser l'adhésif qui servira à la fixation comme barrière ou délimitation à la résine d'enrobage.

A cet effet, l'invention a pour objet un procédé selon les revendications 1 à 12.

Dans le cas de la fabrication en série de supports munis d'un module électronique tels que les cartes à puce, ou munis d'une étiquette, on réalise les étapes de la revendication 1, le film support et le ruban étant fournis en rouleau, le premier comportant une pluralité d'interfaces, le second comportant une pluralité de perforations. Ensuite on enlève la couche de protection du ruban adhésif et on vient découper les modules ou étiquettes avant de les fixer sur un support du corps de la carte par collage par activation du ruban adhésif.

Le procédé selon l'invention est particulièrement avantageux pour la fabrication de cartes à puces car on n'utilise pas de matière consommable spécifique pour réaliser le coffrage de la résine du fait que l'on utilise l'adhésif qui servira à la fixation et le nombre d'étapes est réduit, puisque l'on supprime l'opération isolée de dépôt de la barrière. Par ailleurs, on utilise des équipements et des procédés connus, ce qui entraîne une industrialisation aisée.

La minimisation du nombre d'étapes permet d'augmenter le rendement et de diminu.er les coûts de fabrication.

Dans le cas de microcircuits de petites dimensions, pour lesquelles on n'utilise normalement pas de barrière, l'invention permet d'augmenter le volume de la résine autour des fils de connexion et ainsi d'obtenir un boîtier plus rigide et donc plus résistant aux contraintes mécaniques (flexions et torsions répétées). Cette augmentation de la fiabilité se fait sans augmenter le prix de revient.

L'application du ruban adhésif sur le film support peut être effectuée à différents stades notamment avant le collage des microcircuits sur le film support, après le collage des microcircuits et avant leur connexion, ou après leur connexion.

Selon une autre caractéristique de l'invention, l'épaisseur totale du ruban adhésif avec sa couche externe de protection est au moins égale à l'épaisseur prévue pour la résine de protection ou dite d'enrobage. Ceci permet de bien contenir la résine selon la hauteur souhaitée

De préférence, on adapte la hauteur de la barrière en fonction de la hauteur de la résine souhaitée simplement en variant l'épaisseur de la feuille protectrice. Ainsi, on peut conserver une matière adhésive de très faible épaisseur, ce qui est préférable notamment dans le cas de la fabrication de carte à puce sur le plan collage ou comportement dynamique du module par rapport à la cavité.

La matière d'enrobage en l'occurrence une résine peut être dispensée de différentes manières notamment par pulvérisation, sérigraphie, dispense volumétrique (Glob Top)...

En utilisant une technique de dispense volumétrique, on peut maîtriser une quantité prédéterminée de résine déposée et, par suite, son épaisseur. Par cette technique, contrairement à la pulvérisation, on peut également maîtriser l'endroit de dispense sur le film support notamment sur la zone prévue à l'intérieur d'une perforation, barrière ou délimitation quelconque.

Pour la fixation du module ou antenne sur un support le procédé de l'invention comporte en outre une étape consistant à activer la matière préalablement ou en même temps à un report et pressage sur ledit support.

Dans un cas préféré, le support est un corps de carte à puce ou jeton comportant une cavité (32, 32') destinée à recevoir au moins un microcircuit, ses connexions et ladite résine d'enrobage.

L'invention a également pour objet un module ou étiquette électronique obtenu par les procédés ci dessus. Dans le cas d'un module électronique comportant une antenne, l'antenne peut être réalisée sur la face arrière du film support et dans ce cas le module comporte un second ruban adhésif appliqué sur la face arrière du film support.

Ce second ruban adhésif constitue une couche de protection pour l'antenne.

L'invention a encore pour objet une étiquette électronique comportant un module électronique dans lequel l'interface est une antenne et qui est obtenu par le procédé ci dessus. Une telle étiquette est seulement constituée par le module électronique qui n'est pas "encarté" et conserve la couche externe de protection. Avantageusement, le ruban adhésif est utilisé pour la fixation de l'étiquette sur un support produit.

On obtient donc une étiquette électronique adhésive de faible prix de revient.

On peut prévoir que le ruban adhésif est renforcé, par exemple au moyen de fibres de verre, de manière à rigidifier l'étiquette.

L'invention a encore pour objet une carte à puce ou jeton réalisé selon les procédés conforme à l'invention.

Selon une caractéristique, on peut obtenir une carte à puce standard en reportant le module entièrement dans une cavité de support en particulier un corps de carte, de manière que le module affleure la surface du support.

Selon une caractéristique avantageuse, la carte à puce ou jeton comporte une cavité (32, 32') destinée à recevoir au moins un microcircuit, ses connexions et ladite résine d'enrobage et le film support étant fixé à la surface dudit support en dehors de la cavité. Ainsi, il est aisé de fixer une étiquette ou module de grande dimension (cas d'une interface à antenne de quelques centimètres) sur un corps de carte sans avoir besoin de ménager une cavité spécifique de grande largeur pour le film support.

L'invention a également pour objet une bobine de film support comportant une pluralité de modules ou étiquettes obtenus par le procédé selon les procédés de l'invention.

D'autres caractéristiques et avantages de l'invention ressortiront de la description qui suit, faite à titre illustratif et nullement limitatif, en se référant aux dessins ci-annexés sur lesquels :
- les figures 1A à 1J illustrent un procédé classique de fabrication d'un module électronique avec deux modes de réalisation de la barrière,
- la figure 2 montre l'opération de dépôt du ruban adhésif,
- les figures 3 et 4 illustrent l'opération d'encartage pour les deux modes de réalisation de la barrière,
- les figures 5A à 5G illustrent un procédé de fabrication de carte à puce,
- les figures 6A à 6G illustrent une première variante de réalisation de l'invention, et
- les figures 7 à 9 illustrent d'autres variantes de réalisation de l'invention.

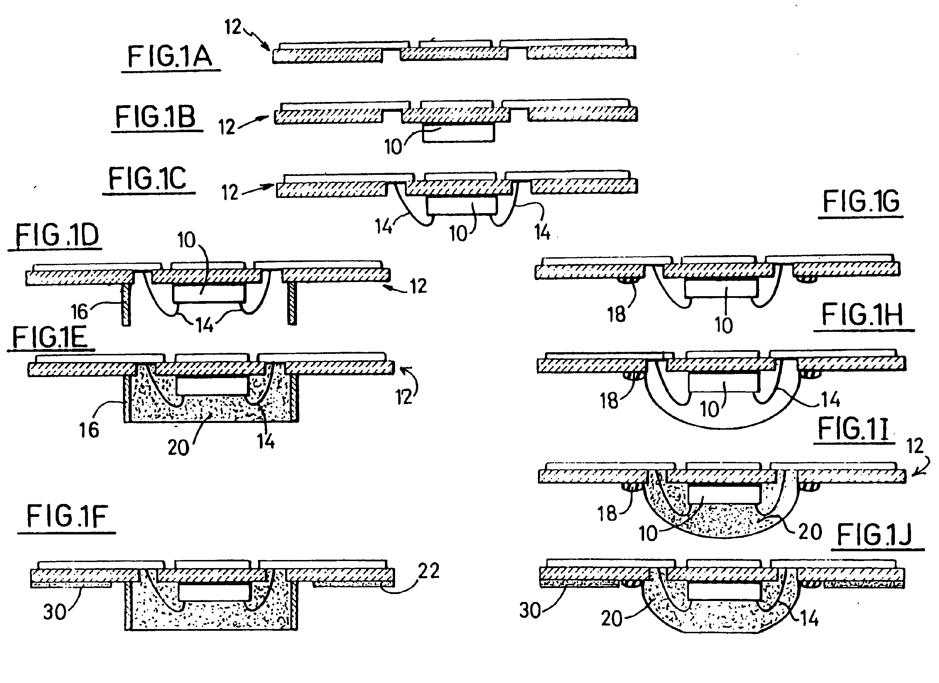

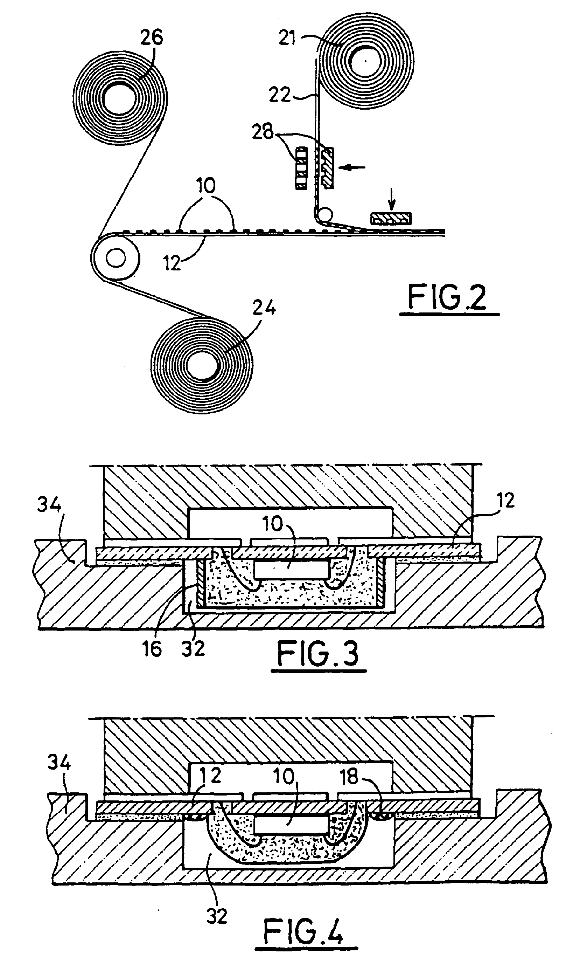

Les figures 1A à 1J représentent un procédé classique de réalisation d'un module électronique destiné à une carte à puce. Les microcircuits 10 sont découpés dans une plaquette et collés sur un film support 12, voir également figure 2. Les connexions d'interface 14 sont réalisées de manière à constituer le module électronique.

Ensuite, lorsque le microcircuit est de surface importante et de forme rectangulaire, on réalise une barrière sur le film support 12 autour du module électronique ainsi obtenu. Selon le procédé illustré aux figures 1D à 1F, la barrière est un cadre métallique estampé 16 collé sur le film support 12 ; selon le procédé illustré aux figures 1G à 1J, la barrière 18 est en polymère, tel qu'une résine époxy, du silicone ou une résine polyester, qui peut être déposé par une technique de dépôt au moyen d'une seringue ("dispense") ou par sérigraphie.

On dépose ensuite une goutte 20 de résine de protection mécanique du module électronique sur le film support 12 dans la zone délimitée par la barrière 16 ou 18.

On dépose ensuite un film adhésif 22 autour du module électronique revêtu de la goutte de résine de protection 20 en vue de l'opération d'encartage du module électronique dans le corps de la carte à puce.

L'opération de dépôt de ce film adhésif 22 est représentée sur la figure 2. On voit un rouleau 24 comportant une série de microcircuits 10 disposés sur un film support 12 et protégés par un film intercalaire 26. Le film intercalaire 26 est enlevé et enroulé sur une bobine annexe. Un troisième rouleau 21 fournit le film adhésif 22 qui est perforé au moyen d'un appareil 28 de manière à présenter des découpes correspondant aux zones des modules électroniques revêtus de la goutte de résine de protection 20 de telle sorte que le film adhésif 22 est constitué de cadres 30 entourant cette zone.

Le film support 12 est alors découpé pour obtenir les modules électroniques individuels qui sont ensuite collés dans un évidement 32 du corps 34 de la carte à puce au moyen du film adhésif 22 qui vient d'être déposé. Cette opération d'encartage est représentée sur les figures 3 et 4 avec les deux modes de réalisation de la barrière 16 et 18.

Avant l'opération de découpe, il peut être nécessaire, dans le cas de résines thermodurcissables, de rectifier l'épaisseur des modules électroniques revêtus de la goutte de résine de protection 20, par exemple par une opération de fraisage agissant sur la goutte de résine de protection 20.

Comme indiqué plus haut, la technique classique de réalisation de la barrière présente de nombreux inconvénients. Elle constitue une opération dont le coût n'est pas négligeable.

La matière utilisée peut entraîner des effets secondaires néfastes ; ainsi, par exemple, si l'on utilise du silicone, il peut se produire une pollution des surfaces devant être collées lors d'étapes ultérieures.

Pour éviter tout débordement de la résine, qui entraîne un rebut, il faut utiliser une technique de dépôt précise de la résine.

L'utilisation de résines thermodurcissables entraîne une opération supplémentaire de rectification de l'épaisseur du module électronique revêtu de la goutte de résine de protection 20.

Comme indiqué plus haut, il existe d'autres techniques de réalisation de la barrière qui nécessitent l'utilisation d'une matière consommable et/ou d'étapes supplémentaires entraînant un surcoût de fabrication.

La présente invention permet d'éviter les inconvénients précités et d'obtenir un module électronique revêtu de la goutte de résine de protection 20 dont le coût de fabrication est réduit. Le principe de l'invention est d'utiliser pour la réalisation de la barrière le film adhésif servant à l'opération ultérieure d'encartage. Il n'y a donc pas de matière consommable ; de plus, l'étape spécifique de réalisation de la barrière est supprimée.

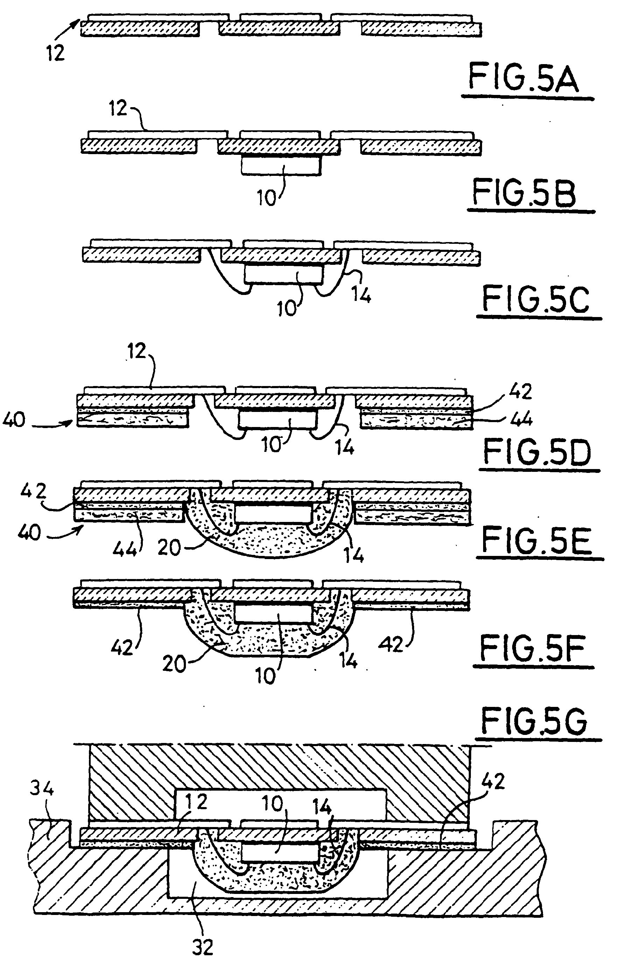

Les figures 5A à 5G représentent un mode de réalisation du module électronique revêtu de la goutte de résine de protection 20. On retrouve aux figures 5A à 5C les deux étapes d'élaboration du film support 12 , l'étape de collage du microcircuit ou puce 10 et l'étape de réalisation des connexions 14 de l'interface.

On dépose ensuite, sur le film support 12, un ruban adhésif 40 qui est perforé par exemple comme le film adhésif 22 sur la figure 2 et qui est constitué d'une couche de matière adhésive 42 revêtue d'une couche de protection externe 44. On procède ensuite au dépôt de la goutte de résine de protection 20, puis on ôte la couche de protection externe 44 pour coller le module électronique dans l'évidement 32 du corps 34 de la carte à puce.

Dans ce mode de réalisation, on utilise une couche de matière adhésive 42 thermoactivable, thermoplastique ou thermoactivable, par exemple l'adhésif TESA 8410 commercialisés par la société BEIERSDORF. '

L'opération de dépose du ruban adhésif 40 sur le film support 12 est effectuée avant le dépôt de la goutte de résine de protection 20 ; elle peut être faite avant le collage des puces 10, avant la réalisation des connexions 14 ou, au plus tard, après cette dernière étape. Il suffit d'utiliser des techniques de collage de puce et de câblage des connexions qui ne nécessitent pas une température pouvant activer la couche de matière adhésive 42.

On peut utiliser, par exemple, pour le collage des puces une colle bicomposant réticulant à la température ambiante ou une colle réticulable par rayonnement ultraviolet ou à une longueur d'onde plus faible ("lumière bleue"). Pour le câblage des connexions, on peut utiliser la technique connue sous le nom de "soudage en biseau" (wedge bonding) utilisant un fil en aluminium soudé par ultrasons. Une autre solution est le "soudage par boule" (ball bonding) en utilisant un paramétrage adapté évitant une température supérieure à 70 °C au niveau de la couche de matière adhésive 42.

Le ruban adhésif 40 comporte une couche de protection externe 44, cela signifie une surface antiadhérente à l'extérieur évitant tout collage intempestif pendant les étapes de fabrication du module électronique.

Selon l'invention, l'épaisseur du ruban adhésif 40 avec sa couche de protection externe 44 est choisi supérieure ou égale à l'épaisseur visée pour la goutte de résine de protection 20.

La résine de protection doit réticuler à faible température. Elle peut être activée par rayonnement ultraviolet ou être un produit bicomposant ou encore réticuler par apport d'humidité.

La résine peut s'entendre au sens de l'invention par tout matériau apte à protéger le microcircuit et ses connexions

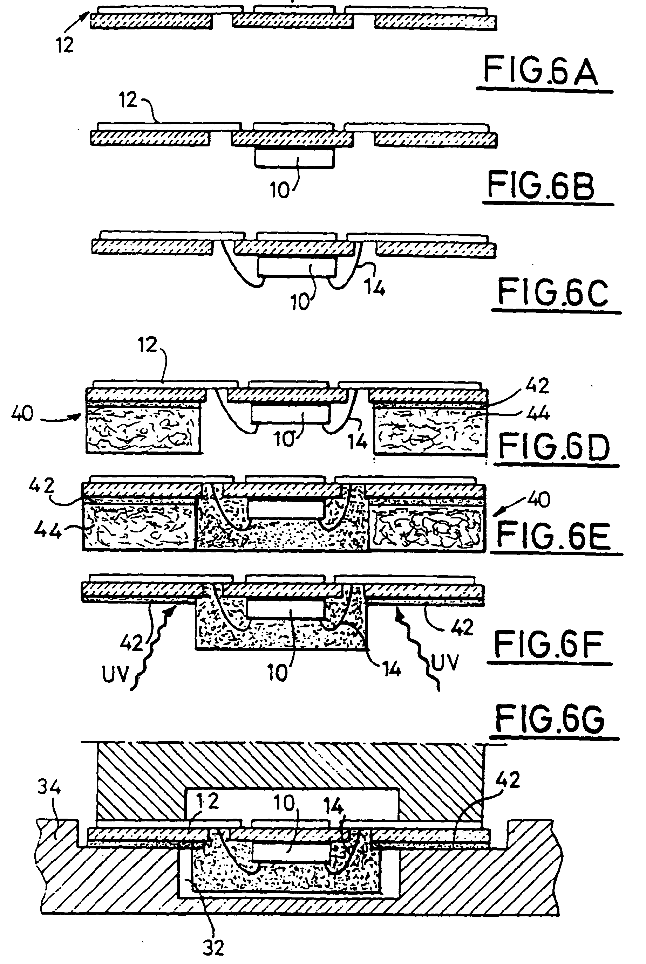

Après la gélification de la goutte de résine de protection 20 ou sa réticulation complète, on ôte la couche de protection externe 44 pour réaliser l'opération d'encartage de manière classique. On pourra, dans le cas d'une couche de protection externe 44 de faible épaisseur exemple qui ne fait pas partie du cadre de l'invention rectifier l'épaisseur de la goutte de résine de protection 20 par fraisage. Les figures 6A à 6G représentent un autre mode de réalisation utilisant une couche de matière adhésive 42 réticulable par rayonnement ultraviolet qui est basé sur l'utilisation d'un polymère thermodurcissable (par exemple époxide ou uréthane) dont le démarrage de la polymérisation est initié par un rayonnement ultraviolet avec association éventuelle à une formulation thermoplastique (par exemple polyester), pour rendre le produit activable, le produit devenant collant quand il est chauffé. Comme on le voit sur la figure 6, la couche de matière adhésive 42 est activée par rayonnement ultraviolet après avoir ôté la couche de protection externe 44 et juste avant la mise en place dans la cavité 32 du corps 34. Il n'est donc plus nécessaire d'appliquer une température trop élevée pour polymériser la couche de matière adhésive 42. Cela signifie que la déformation du dos de la cavité 32, qui est généralement créée par un pressage à haute température, est nettement atténuée par rapport au cas d'un adhésif réticulant avec apport de chaleur.

L'avantage de cette matière adhésive est qu'elle peut être exposée à une température de l'ordre de 80 à 120 °C sans subir de dégradation ; cela signifie qu'une résine de protection thermodurcissable peut être coulée et polymérisée dans l'évidement aménagé par perforation dans le ruban adhésif 40.

L'invention permet donc de réaliser des modules électroniques comportant une interface à bornier de contact ou à antenne. Dans le cas d'un module électronique dont l'interface est une antenne, l'invention permet de réaliser des étiquettes électroniques destinées au marquage de produits, commercialisés, par exemple, dans les magasins de vente à grande surface. Ces étiquettes électroniques servent notamment à détecter les produits par passage dans une zone de surveillance. Ces étiquettes peuvent ou non conserver la couche de protection externe 44 qui n'est donc pas ôtée. Toutefois, selon une variante préféré qui vise à une fixation en série du module ou de l'étiquette sur des produits notamment des supports à puce ou des produits industriels, il convient de retirer la feuille de protection préalablement à la découpe. Dans un exemple, le module est découpé par un poinçon et transféré à un outil d'insertion et de fixation sur le produit considéré.

Par ailleurs la couche adhésive du ruban adhésif peut être utilisée pour le collage de l'étiquette électronique sur le produit.

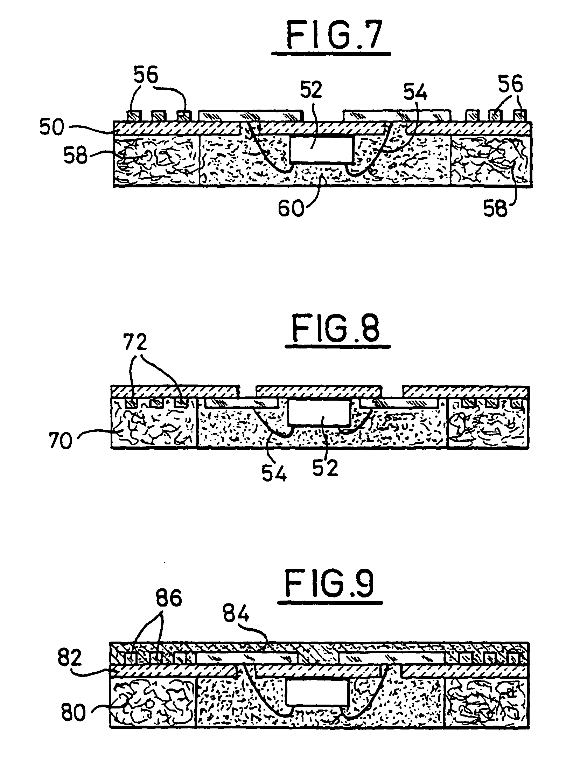

La figure 7 représente une telle étiquette électronique qui comporte un film support 50 un microcircuit 52, des connexions 54 à une antenne 56 constituée par des spires métalliques déposées sur la face arrière du film support 50 et un ruban adhésif 58. Le microcircuit 52 est noyé dans une goutte 60 de résine protectrice.

Dans ce cas, le ruban adhésif 58 permet d'obtenir une étiquette d'épaisseur constante. Si on souhaite obtenir une étiquette plus résistante, on peut utiliser un ruban adhésif renforcé, par exemple, par des fibres de verre.

L'antenne est constituée d'un ruban métallique par exemple, en cuivre ou en aluminium, gravé chimiquement ou estampé sur un diélectrique, par exemple, verre/époxy, polyester, polyimide, polyéthylène, polypropylène.

L'antenne peut être réalisée du même côté que le microcircuit (face avant du film support 50) ou de l'autre côté (face arrière).

Dans le premier cas représenté sur la figure 8, le ruban adhésif 70 permet de protéger les spires de l'antenne 72 les contraintes climatiques pouvant dégrader - par exemple par corrosion ou abrasion mécanique - les caractéristiques de l'antenne. De plus, la manipulation des étiquettes pourra être faite sans perturber le fonctionnement par mise à la terre ou mise en court-circuit des spires entre elles.

Dans le deuxième cas représenté sur la figure 9, le ruban adhésif 80 servant à réaliser la barrière est déposé sur le film support 82 et on peut déposer sur la face arrière de ce dernier une feuille protectrice 84 protégeant l'antenne 86.

On voit que l'invention permet de réaliser à un faible coût un module électronique pour carte à puce du type à contact, sans contact ou hybride. En particulier, on n'utilise pas de matière consommable et le nombre des étapes du procédé de fabrication est réduit.

Par ailleurs, le procédé selon l'invention est mis en oeuvre en utilisant des équipements et des étapes de fabrication classiques, ce qui augmente sa fiabilité.

En outre, on peut obtenir, toujours à un faible coût, une étiquette électronique de grande fiabilité en ce qui concerne sa résistance mécanique.

Revenant sur la variante du procédé de l'invention selon lequel on fournit une matière adhésive à adhésivité activable (42) la matière peut être répartie des différentes manières notamment sous forme de stries ou de points.

De même la matière adhésive peut être présentée sous forme de film tel qu'un film thermofusible. Ce film peut être perforé comme le ruban à feuille protectrice.

La matière adhésive peut encore être un film multicouche. Les couches adhésives peuvent être activables différemment notamment par rayonnement ou par énergie thermique.

Selon un mode de dispense pratique, on peut utiliser la technique sérigraphique.

Selon les procédés, la matière adhésive étant thermoactivable, la résine d'enrobage peut être un monocomposant ou un polymère bicomposant polymérisant à une température inférieure ou égale à 70 °C.

## Revendications

1. Procédé pour la fabrication d'au moins un support électronique, ledit support électronique comprenant un film support, au moins un microcircuit (10 ; 50 ; 82) et au moins une interface (56; 72; 86) à contacts et/ou antenne reliés ensemble par des connexions (14 ; 54) et disposés sur le film support, une résine d'enrobage protégeant au moins ledit microcircuit et lesdites connexions, ladite résine d'enrobage étant disposée sur une zone prédéterminée, une matière (42, 58, 70, 80) adhérant elle-même au film support,
ledit procédé comprenant les étapes suivantes selon lesquelles:
a) on fournit un film support comportant au moins une interface à contacts et/ou antenne,
b) on fournit une matière présentant une adhésivité activable (42, 58, 70, 80),
c) on dépose la matière de manière qu'elle soit répartie ou s'étende sur tout le film support autour de ladite zone et présente une délimitation autour de ladite zone et on active ladite matière pour que celle-ci adhère au film support,
d) on dispense la résine d'enrobage sur la zone prévue à l'intérieur de ladite délimitation de manière que l'étalement de la résine d'enrobage stoppe à son contact, le microcircuit ayant été fixé sur le film support et connecté à l'interface après l'une des étapes précédentes,
**caractérisé en ce que** la délimitation a une épaisseur totale au moins égale à l'épaisseur prévue pour la résine d'enrobage.

2. Procédé selon la revendication 1, **caractérisé en ce** ladite matière comprend une feuille protectrice, ladite feuille protectrice comportant au moins une perforation correspondant à la zone de la résine,

3. Procédé selon la revendication 2, **caractérisé en ce qu'**il comporte en outre une étape selon laquelle on retire ladite feuille protectrice et on découpe le film support pour en extraire un module ou ladite antenne.

4. Procédé selon la revendication 2, **caractérisé en ce qu'**il comporte en outre une étape selon laquelle on découpe le film support pour en extraire un module et on retire ladite feuille protectrice.

5. Procédé selon l'une des revendications 1 ou 2, **caractérisé en ce qu'**il comporte en outre une étape selon laquelle on découpe le film support pour en extraire un module.

6. Procédé selon l'une quelconque des revendications 1 à 5, **caractérisé en ce que** ladite matière est un matériau thermoactivable et **en ce que** la résine d'enrobage est polymérisable par irradiation.

7. Procédé selon l'une quelconque des revendications 1 à 6, **caractérisé en ce que** ladite matière est thermoactivable et **en ce que** la résine d'enrobage est un monocomposant polymérisant à une température inférieure ou égale à 70 °C.

8. Procédé selon l'une quelconque des revendications 1 à 7, **caractérisé en ce que** ladite matière est thermoactivable et **en ce que** la résine d'enrobage est un polymère bicomposant polymérisant à une température inférieure ou égale à 70 °C.

9. Procédé selon l'une des revendications précédentes, **caractérisé en ce que** ladite matière comprend un film thermofusible comportant au moins une perforation correspondant à ladite zone.

10. Procédé selon l'une quelconque des revendications précédentes, **caractérisé en ce que** ladite matière est un film multicouche.

11. Procédé selon l'une quelconque des revendications 3 à 10, **caractérisé en ce qu'**il comprend une étape de fixation du module ou une antenne sur un support et une étape consistant à activer la matière préalablement ou en même temps à un report et pressage sur ledit support.

12. Procédé selon la revendication 11, **caractérisé en ce que** ledit support est un corps de carte ou un jeton comportant une cavité (32, 32') destinée à recevoir au moins un microcircuit, ses connexions et ladite résine d'enrobage.

13. Support électronique comprenant :
- un film support,
- une matière (42, 58, 70, 80) adhérant elle-même au film support, ladite matière s'étendant ou étant répartie sur tout le film support autour d'une zone du film support et définissant une délimitation autour de ladite zone,
- au moins un microcircuit (10 ; 50 ; 82) dans ladite zone
- et au moins une interface (56; 72; 86) à contacts et/ou antenne reliés au microcircuit par des connexions (14 ; 54),
- une résine d'enrobage protégeant au moins ledit microcircuit et lesdites connexions, ladite résine étant disposée à l'intérieur et au contact de ladite délimitation, **caractérisé en ce que** la délimitation a une épaisseur totale au moins égale à l'épaisseur de la résine d'enrobage.

14. Support électronique selon la revendication 13, **caractérisé en ce que** ladite matière contient une feuille protectrice (44) comportant au moins une perforation correspondant à la zone de la résine.

15. Support électronique, selon l'une des revendications 13 à 14, **caractérisé en ce que** l'antenne (56) est disposée sur un côté du film support (50) alors que le microcircuit (52) est disposé du côté opposé.

16. Support électronique comportant une antenne selon l'une des revendications 13 à 14, **caractérisé en ce que** l'antenne (72) est disposée du même côté du film support (50) que le microcircuit (52) et recouverte par la couche de matière adhésive (70).

17. Support électronique comportant une antenne selon l'une des revendications 13 à 14, **caractérisé en ce que** l'antenne (72) est disposée sur un côté du film support (50) opposé à celui portant l'interface à contact.

18. Support électronique selon l'une des revendications 13 à 17, **caractérisé en ce qu'**il comporte un second ruban adhésif de protection (84) appliqué sur l'antenne.

19. Support électronique selon la revendication 18, **caractérisée en ce que** ladite matière (40 ; 58 ; 70 ; 80) comporte des fibres de renfort.

20. Support électronique selon l'une des revendications 13 à 19, **caractérisée en ce que** ladite matière (40 ; 58 ; 70 ; 80) comprend un thermodurcissable et/ou un thermoplastique.

21. Produit comportant ou constituant un support électronique tel qu'une carte, un module, une étiquette électronique, un jeton obtenu selon le procédé à l'une des revendications 1 à 12 ou selon l'une des revendications 13 à 20.

22. Produit selon la revendication 21, comportant une surface et une cavité, **caractérisé en ce que** ledit support électronique est fixé entièrement dans la cavité et affleure à la surface du support.

23. Produit selon la revendication 22, comportant une surface et une cavité recevant le microcircuit et la résine d'enrobage, **caractérisé en ce que** le film support (50) est fixé à la surface dudit support en dehors de la cavité.

24. Film support bobiné comportant une pluralité de supports électroniques selon l'une des revendications 13 à 20.

## Claims

1. A method for manufacturing at least one electronic support, said electronic support including a support film, at least one microcircuit (10; 50; 82) and at least one interface (56; 72; 86) with contacts and/or an antenna connected together by means of connexions (14; 54) and positioned on the support film, a coating resin protecting at least said microcircuit and said connexions, said coating resin being positioned on a predetermined area, with a material (42, 58, 70, 80) itself adhering to the support film:
said method including the following steps, according to which:
a) a film support including at least one interface with contacts and/or an antenna is provided,
b) a material having an actuatable adhesiveness (42, 58, 70, 80) is provided,
c) the material is deposited so that it is distributed or expands on the whole support film around said area and has a limit around said area, and said material is actuated so that it does not adhere to the support film,
d) the coating resin is dispensed onto the area provided therefor inside said limit, so that the spreading of the coating resin stops when contacting it, with the microcircuit being fixed on the support film and connected to the interface after one of the preceding steps,
**characterized in that** the limit has a total thickness at least equal to the thickness provided for the coating resin.

2. A method according to claim 1, **characterized in that** said material includes a protective sheet, said protective sheet including at least one perforation corresponding the resin area.

3. A method according to claim 2, **characterized in that** it further includes a step during which said protective sheet is removed and the support film is cut for extracting a module or said antenna therefrom.

4. A method according to claim 2, **characterized in that** it further includes a step during which the support film is cut for extracting a module therefrom, and said protective sheet is removed.

5. A method according to claims 1 or 2, **characterized in that** it further includes a step during which the support film is cut for extracting a module therefrom.

6. A method according to any one of claims 1 to 5, **characterized in that** said material is thermo-actuatable and **in that** the coating resin is polymerizable by irradiation.

7. A method according to any one of claims 1 to 6, **characterized in that** said material is thermo-actuatable and **in that** the coating resin is a one-component material polymerizing at a temperature lower than or equal to 70°C.

8. A method according to any one of claims 1 to 7, **characterized in that** said material is thermo-actuatable and **in that** the coating resin is a dual component polymer polymerizing at a temperature lower than or equal to 70°C.

9. A method according to one of the preceding claims, **characterized in that** said material includes a thermofusible film including at least one perforation corresponding to said area.

10. A method according to any one of the preceding claims, **characterized in that** said material is a multi-layer film.

11. A method according to any one of claims 3 to 10, **characterized in that** it includes a step of fixing the module or an antenna on a support and a step consisting in actuating the material prior to or simultaneously with a transfer and pressing onto said support.

12. A method according to claim 11, **characterized in that** said support is a card body or a token including a cavity (32, 32') intended to receive at least one microcircuit, the connections thereof and said coating resin.

13. An electronic support including:
- a support film,
- a material (42, 58, 70, 80) itself adhering onto the whole support film around an area of the support film and defining a limit around said area,
- at least one microcircuit (10; 50; 82) in said area,
- and at least one interface (56; 72; 86) with contacts and/or an antenna connected to the microcircuit by means of connections (14; 54),
- a coating resin protecting at least said microcircuit and said connections, said resin being positioned inside, and in contact with said limit, **characterized in that** the limit has a total thickness at least equal to the thickness of the coating resin.

14. An electronic support according to claim 13, **characterized in that** said material contains a protective sheet (44) including at least one perforation corresponding to the resin area.

15. An electronic support including an antenna according to one of claims 13 to 14, **characterized in that** the antenna (56) is positioned on one side of the support film (50) whereas the microcircuit (52) is positioned on the opposite side.

16. An electronic support including an antenna according to one of claims 13 to 14, **characterized in that** the antenna (72) is positioned on the same side of the support film (50) as the microcircuit (52) and covered with the adhesive material layer (70).

17. An electronic support including an antenna according to one of claims 13 to 14, **characterized in that** the antenna (72) is positioned on one side of the support film (50) opposite the one carrying the contact interface.

18. An electronic support according to one of claims 13 to 17, **characterized in that** it includes a second protection adhesive tape (84) applied onto the antenna.

19. An electronic support according to claim 18, **characterized in that** said material (40; 58; 70; 80) includes reinforcing fibres.

20. An electronic support according to one of claims 13 to 19, **characterized in that** said material (40; 58; 70; 80) includes a thermosetting and/or thermoplastic element.

21. A product including or constituting an electronic support such as a card, a module, an electronic label, a token obtained according to the method of one of claims 1 to 12 or according to one of claims 13 to 20.

22. A product according to claim 21, including a surface and a cavity, **characterized in that** said electronic support is totally fixed in the cavity and is flush with the surface of the support.

23. A product according to claim 22, including a surface and a cavity receiving the microcircuit and the coating resin, **characterized in that** the support film (50) is fixed to the surface of said support out of the cavity.

24. A coiled support film including a plurality of electronic supports according to one of claims 13 to 20.

## Patentansprüche

1. Verfahren zur Herstellung mindestens eines elektronischen Trägers, wobei der genannte elektronische Träger eine Trägerfolie, mindestens eine Mikroschaltung (10; 50; 82) und mindestens eine Schnittstelle (56; 72; 86) mit Kontakten und/oder Antenne umfasst, die über Anschlüsse (14; 54) miteinander verbunden und auf der Trägerfolie angeordnet sind, wobei ein Umhüllungsharz mindestens die genannte Mikroschaltung und die genannten Anschlüsse schützt, wobei das genannte Umhüllungsharz auf einer vorbestimmten Zone angeordnet ist, wobei eine Substanz (42, 58, 70, 80) ihrerseits an der Trägerfolie haftet,
wobei das genannte Verfahren die folgenden Schritte umfasst, gemäß denen:
a) man eine Trägerfolie bereitstellt, die mindestens eine Schnittstelle mit Kontakten und/oder Antenne umfasst,
b) man eine Substanz (42, 58, 70, 80) bereitstellt, die eine aktivierbare Haftbarkeit aufweist,
c) man die Substanz derart aufträgt, dass sie sich über die gesamte Trägerfolie um die genannte Zone herum verteilt bzw. erstreckt, und eine Begrenzung um die genannte Zone herum aufweist, und man die genannte Substanz aktiviert, damit sie an der Trägerfolie haftet,
d) man das Umhüllungsharz auf die innerhalb der genannten Begrenzung vorgesehene Zone aufträgt, so dass das Auftragen des Umhüllungsharzes bei seinem Kontakt die Mikroschaltung stoppt, die auf der Trägerfolie befestigt und nach einem der vorangehenden Schritte an die Schnittstelle angeschlossen wurde,
**dadurch gekennzeichnet, dass** die Begrenzung eine Gesamtdicke aufweist, die mindestens der für das Umhüllungsharz vorgesehenen Dicke entspricht.

2. Verfahren gemäß Anspruch 1, **dadurch gekennzeichnet, dass** die genannte Substanz eine Schutzfolie umfasst, wobei die genannte Schutzfolie mindestens eine der Zone des Harzes entsprechende Perforation aufweist.

3. Verfahren gemäß Anspruch 2, **dadurch gekennzeichnet, dass** es ferner einen Schritt umfasst, gemäß dem man die genannte Schutzfolie abzieht und die Trägerfolie ausschneidet, um ein Modul oder die genannte Antenne aus ihr herauszuführen.

4. Verfahren gemäß Anspruch 2, **dadurch gekennzeichnet, dass** es ferner einen Schritt umfasst, gemäß dem man die Trägerfolie ausschneidet, um ein Modul aus ihr herauszuführen, und man die genannte Schutzfolie abzieht.

5. Verfahren gemäß einem der Ansprüche 1 oder 2, **dadurch gekennzeichnet, dass** es ferner einen Schritt umfasst, gemäß dem man die Trägerfolie ausschneidet, um ein Module aus ihr herauszuführen.

6. Verfahren gemäß einem der Ansprüche 1 bis 5, **dadurch gekennzeichnet, dass** die genannte Substanz ein wärmeaktivierbares Material ist, und dass das Umhüllungsharz durch Bestrahlung polymerisierbar ist.

7. Verfahren gemäß einem der Ansprüche 1 bis 6, **dadurch gekennzeichnet, dass** die genannte Substanz wärmeaktivierbar ist, und dass das Umhüllungsharz eine Monokomponente ist, die bei einer Temperatur von weniger oder gleich 70°C polymerisiert.

8. Verfahren gemäß einem der Ansprüche 1 bis 7, **dadurch gekennzeichnet, dass** die genannte Substanz wärmeaktivierbar ist, und dass das Umhüllungsharz ein Zweikomponentenpolymer ist, das bei einer Temperatur von weniger oder gleich 70°C polymerisiert.

9. Verfahren gemäß einem der vorangehenden Ansprüche, **dadurch gekennzeichnet, dass** die genannte Substanz eine wärmeschmelzbare Folie umfasst, die mindestens eine der genannten Zone entsprechende Perforation aufweist.

10. Verfahren gemäß einem der vorangehenden Ansprüche, **dadurch gekennzeichnet, dass** die genannte Substanz eine mehrschichtige Folie ist.

11. Verfahren gemäß einem der Ansprüche 3 bis 10, **dadurch gekennzeichnet, dass** es einen Befestigungsschritt des Moduls oder einer Antenne auf einem Träger umfasst, sowie einen Schritt, der darin besteht, die Substanz vor oder gleichzeitig mit einem Übertrag und einem Anpressen auf dem genannten Träger zu aktivieren.

12. Verfahren gemäß Anspruch 11, **dadurch gekennzeichnet, dass** der genannte Träger ein Kartenkörper oder ein Jeton ist, der eine Vertiefung (32, 32') aufweist, um mindestens eine Mikroschaltung, ihre Anschlüsse und das genannte Umhüllungsharz aufzunehmen.

13. Elektronischer Träger, bestehend aus:
- einer Trägerfolie,
- einer Substanz (42, 58, 70, 80), die ihrerseits auf der Trägerfolie haftet, wobei sich die genannte Substanz über die gesamte Folie um eine Zone der Trägerfolie herum erstreckt bzw. verteilt und eine Begrenzung um die genannte Zone herum definiert,
- mindestens einer Mikroschaltung (10; 50; 82) in der genannten Zone, und
- mindestens einer Schnittstelle (56; 72; 86) mit Kontakten und/oder Antenne, die über Anschlüsse (14; 54) mit der Mikroschaltung verbunden sind,
- einem Umhüllungsharz, das mindestens die genannte Mikroschaltung und die genannten Anschlüsse schützt, wobei das genannte Harz innerhalb der genannten Begrenzung angeordnet ist oder mit ihr in Kontakt steht,
**dadurch gekennzeichnet, dass** die Begrenzung eine Gesamtdicke aufweist, die mindestens der Dicke des Umhüllungsharzes entspricht.

14. Elektronischer Träger gemäß Anspruch 13, **dadurch gekennzeichnet, dass** die genannte Substanz eine Schutzfolie (44) umfasst, die mindestens eine der Zone des Harzes entsprechende Perforation aufweist.

15. Elektronischer Träger gemäß einem der Ansprüche 13 bis 14, **dadurch gekennzeichnet, dass** die Antenne (56) auf einer Seite der Trägerfolie (50) angeordnet ist, während die Mikroschaltung (52) auf der gegenüberliegenden Seite angeordnet ist.

16. Elektronischer Träger mit einer Antenne gemäß einem der Ansprüche 13 bis 14, **dadurch gekennzeichnet, dass** die Antenne (72) auf derselben Seite der Trägerfolie (50) angeordnet ist wie die Mikroschaltung (52) und von der Haftstoffschicht (70) überdeckt ist.

17. Elektronischer Träger mit einer Antenne gemäß einem der Ansprüche 13 bis 14, **dadurch gekennzeichnet, dass** die Antenne (72) auf einer Seite der Trägerfolie (50) angeordnet ist, die derjenigen gegenüberliegt, die die Kontaktschnittstelle trägt.

18. Elektronischer Träger gemäß einem der Ansprüche 13 bis 17, **dadurch gekennzeichnet, dass** er einen zweiten Schutzhaftstreifen (84) umfasst, der an der Antenne angebracht ist.

19. Elektronischer Träger gemäß Anspruch 18, **dadurch gekennzeichnet, dass** die genannte Substanz (40; 58; 70; 80) Verstärkungsfasern umfasst.

20. Elektronischer Träger gemäß einem der Ansprüche 13 bis 19, **dadurch gekennzeichnet, dass** die genannte Substanz (40; 58; 70; 80) einen Wärmehärter und/oder einen Thermoplast umfasst.

21. Produkt, das einen elektronischen Träger wie eine Karte, ein Modul, ein elektronisches Etikett, einen Jeton umfasst, hergestellt gemäß dem Verfahren nach einem der Ansprüche 1 bis 12 oder nach einem der Ansprüche 13 bis 20.

22. Produkt gemäß Anspruch 21, bestehend aus einer Fläche und einer Vertiefung, **dadurch gekennzeichnet, dass** der genannte elektronische Träger vollständig in der Vertiefung befestigt ist und mit der Oberfläche des Trägers bündig abschließt.

23. Produkt gemäß Anspruch 22, bestehend aus einer Fläche und einer Vertiefung, die die Mikroschaltung und das Umhüllungsharz aufnimmt, **dadurch gekennzeichnet, dass** die Trägerfolie (50) an der Oberfläche des genannten Trägers außerhalb der Vertiefung befestigt ist.

24. Gewickelte Trägerfolie, die eine Mehrzahl elektronischer Träger gemäß einem der Ansprüche 13 bis 20 umfasst.
